# EUROPÄISCHE PATENTSCHRIFT

(11) **EP 4 016 092 B1**
(45) Veröffentlichungstag und Bekanntmachung des Hinweises auf die Patenterteilung: **13.11.2024**
(21) Anmeldenummer: 21020631.4
(22) Anmeldetag: 09.12.2021
(51) Int. Cl.: G01R 21/00, G01R 27/06, G01R 1/04

(54) **HF-LEISTUNGS-MESSMODUL UND BAUGRUPPENTRÄGER UMFASSEND DAS HFLEISTUNGS-MESSMODUL**
HF POWER MEASURING MODULE AND MODULE CARRIER COMPRISING THE HF POWER MEASURING MODULE
MODULE DE MESURE DE LA PUISSANCE RF ET PORTE-MODULE COMPRENANT LE MODULE DE MESURE DE LA PUISSANCE RF

(30) Priorität: 09.12.2020 DE 102020132857
(43) Veröffentlichungstag der Anmeldung: 22.06.2022
(73) Patentinhaber: Mayr, Ralf, 64625 Bensheim (DE)
(72) Erfinder: Mayr, Ralf, 64625 Bensheim (DE)
(74) Vertreter: Völger, Karl Wolfgang

(56) Entgegenhaltungen:
- CN-U- 207 586 311
- US-A1- 2007 109 755
- US-A1- 2018 321 293
- US-A1- 2020 256 909
- ANONYMOUS: "Agilent V3500A Handheld RF Power Meter", 26 March 2010 (2010-03-26), pages 1 - 2, XP055921179, Retrieved from the Internet <URL:https://assets.testequity.com/te1/Documents/pdf/V3500A-QFS.pdf> [retrieved on 20220513]
- ANONYMOUS: "RF design launches solution for applications monitoring", 11 January 2021 (2021-01-11), pages 1 - 1, XP055921190, Retrieved from the Internet <URL:https://news.satnews.com/2021/01/11/rf-design-launches-solution-for-applications-monitoring/> [retrieved on 20220513]
- CHEREPANOV ALEXANDER ET AL: "Dynamic range extension method for microwave power meters", 31 January 2019 (2019-01-31), ITM Web of Conferences, pages 1 - 9, XP055921213, Retrieved from the Internet <URL:https://www.researchgate.net/publication/337583348_Dynamic_range_extension_method_for_microwave_power_meters> [retrieved on 20220514], DOI: 10.1051/itmconf

## Beschreibung

Zur Überwachung von Leistungspegeln in hochfrequenten Infrastrukturen wie beispielsweise in Satelliten-Bodenstationen kommen unter anderem HF Leistungsmessköpfe, auch bekannt als HF-Sensor, Wattmeter oder mit ähnlichen Bezeichnungen, zum Einsatz. Hauptsächlich werden diese in den infrastrukturbedingten Frequenzbereichen eingesetzt, also z.B. in Satellitenübertragungsstrecken in den systembedingten Zwischen- und Sende- / Empfangsfrequenzen wie das L-Band, C-Band etc. Um eine lückenlose Überwachung z.B. einer gesamten Sendestrecke zu gewährleisten, sind an mehreren Messpunkten solche HF-Leistungsmessköpfe notwendig.

Dies kann durchaus mit handelsüblichen HF-Wattmetern erfolgen, resultiert aber in erheblichen Kosten, da diese Wattmeter eine sehr hohe Präzision und Genauigkeit besitzen, was aber für eine solche Anwendung unnötig und übertrieben ist. Des Weiteren bieten diese Messeinrichtungen gar keine oder nur mit Zusatzeinrichtungen die Möglichkeit, diese an eine Netzwerkinfrastruktur anzubinden, um eine ferngesteuerte Abfrage der Parameter und möglicher Alarme zu ermöglichen.

Es besteht daher der Bedarf an einem neuartigen HF-Leistungs-Messmodul, das eine maximale Flexibilität bei niedrigen Kosten unter Verwendung handelsüblicher Komponenten erreichen kann. Ein kompaktes, tragbares und kostengünstiges HF-Leistungsmessgerät das HF-Leistungsmessungen in Laborqualität sowohl im Feld als auch in Forschungsund Entwicklungslaborumgebungen durchführt, ist aus "Agilent V3500A Handheld RF Power Meter", https://assets.testequity.com/te1/Documents/pdf/V3500A-QFS.pdf bekannt. Das HF-Leistungsmessgerät verfügt dabei über folgende Funktionen: Typ-N-Stecker für den HF-Eingang, eingebautes Display und integrierter Leistungssensor, die Tastenfunktion "Nullstellen" die eine genauere Messung bei niedrigen Leistungsstufen ermöglicht, Pfeiltasten für Menüauswahl und Einstellungen, USB-Mini-B-Anschluss ermöglicht Fernprogrammierung und Stromanschluss und externer Stromanschluss (Verwendung mit optionalem Netzteil). HF-Leistungsmessgerät ist charakterisiert durch einen breiten Frequenzbereich (10 MHz bis 6 GHz) mit großem Dynamikbereich (-63 dBm bis +20 dBm). Die Einschränkung dieses HF-Leistungsmessgerätes besteht jedoch darin, dass es weder allein noch in Kombination mit anderen HF-Leistungsmessgeräten des gleichen Typs in einen Baugruppenträger integriert werden kann.

Der vorliegenden Erfindung liegt daher die Aufgabe zugrunde, ein maximal flexibles und kostengünstiges HF-Leistungs-Messmodul bereitzustellen und einen Baugruppenträger zur Aufnahme dieses HF-Leistungs-Messmoduls anzugeben.

Die Lösung der Aufgabe erfolgt durch die Merkmale der unabhängigen Ansprüche 1 und 6. Vorteilhafte Ausgestaltungen sind in den Unteransprüchen angegeben.

Unter "Messeinrichtung für Hochfrequenzleistung" wird im Rahmen der vorliegenden Erfindung ein Gerät zur flexiblen oder auch stationären Verwendung bei gleichzeitiger einfachen Handhabung und dennoch hochwertiger Qualität verstanden.

Eine "HF-Schnittstelle" und eine "HF-Eingangsstufe" sind erfindungsgemäß vorzugsweise ein Schaltungsteil mit für den speziellen Frequenzbereich ausgelegten Eigenschaften wie Frequenzgangentzerrung, Dynamikerweiterung und Temperaturkompensation.

Die Anzeigeeinrichtung (2) kann in einer bevorzugten Ausführungsform ein LCD oder OLED bzw. Vergleichbares sein, während die Bedieneinrichtung (3) insbesondere als Tasten oder Knopf mit Tastfunktion ausgeführt ist.

Die erfindungsgemäß vorgesehene erste Steckvorrichtung (5) dient einerseits rein mechanisch zum Positionieren des HF-Leistungs-Messmoduls in einem nachstehend noch beschriebenen Baugruppenträger. Andererseits wird mit der ersten Steckvorrichtung (5) das HF-Leistungs-Messmodul verriegelt und gleichzeitig die Versorgung mit der notwendigen Betriebsspannung sichergestellt.

Die Status-Anzeige (12) kann insbesondere eine Alarm-Lampe zur Anzeige von irregulären Betriebszuständen sein.

Das erfindungsgemäße HF-Leistungs-Messmodul weist zunächst den Vorteil eines kompakten Designs auf, was eine Verwendung als flexibles, gut handhabbares Gerät (sog. "Handheld") ermöglicht. Darüber hinaus kann es im Verbund mehrerer HF-Leistungs-Messmodule schnell und einfach zu einem stationären Gerät kombiniert werden. Das erfindungsgemäße HF-Leistungs-Messmodul ist für eine einfache und schnelle Anbindung der Stromversorgung (6) und der zur Verfügung gestellten Daten-Verbindung (z.B. Ethernet) ausgelegt.

Das erfindungsgemäße HF-Leistungs-Messmodul setzt grundsätzlich günstige handelsübliche Komponenten ein. Dadurch werden die Kosten niedrig gehalten, ohne die Funktionalität zu beeinträchtigen.

Das HF-Leistungs-Messmodul umfasst ferner eine

Schaltung zur Erweiterung des Dynamikbereichs der HF-Messung mit und für integrierte Schaltungen.

Mit diesen erfindungsgemäßen Zusatzfunktionen wird die Messdynamik der verwendeten günstigen handelsüblichen Komponenten von einschlägigen Halbleiterherstellern deutlich erweitert, insbesondere auf einen Messbereich von bis zu über 90 dB. Damit ist es möglich, systembedingten Pegelverhältnissen gerecht zu werden, ohne dabei auf teure Lösungen zurückgreifen zu müssen.

Es hat sich als vorteilhaft herausgestellt, wenn die Messeinrichtung ferner einen Ethernet-Controller aufweist. Dies bietet die Möglichkeit, zum einen über ein drahtgebundenes Netzwerk oder über ein Funknetz (WLAN) mit dem HF-Leistungs-Messmodul als Handheld-Gerät oder mehrfach in einem Baugruppenträger zu kommunizieren.

Zur weiteren Verbesserung der Messgenauigkeit des erfindungsgemäßen HF-Leistungs-Messmoduls ist die interne Stromversorgung für die Messeinrichtung rauscharm ausgeführt.

Erfindungsgemäß bevorzugt ist die zumindest eine Kommunikationsschnittstelle (7) eine Ethernet-Schnittstelle.

Die vorstehend bereits ausgeführte gute Handhabbarkeit des erfindungsgemäßen HF-Leistungs-Messmoduls als Handheld-Gerät wird insbesondere erreicht, wenn dieses die Maße 105 mm x 40 mm x 125 mm (d.h. B x H x T) aufweist. Abhängig von der tatsächlichen Verwendung und der möglichen Einbausituation des erfindungsgemäßen HF-Leistungs-Messmoduls können diese Maße in gewissen Grenzen variiert werden, solange die gute Handhabbarkeit als Handheld-Gerät gewährleistet bleibt.

Mit diesen Maßen wird zudem nicht nur eine gute Handhabbarkeit gewährleistet, die erfindungsgemäß ganz besonders bevorzugten Maße machen das erfindungsgemäße HF-Leistungs-Messmodul auch in einen nachstehend noch beschriebenen Baugruppenträger einbaubar, ohne dass ein Werkzeug benötigt wird. Zudem müssen keine bereits bestehenden Kabel-Verbindungen entfernt werden.

Die vorstehenden Ausführungen und Bevorzugungen im Hinblick auf das erfindungsgemäße HF-Leistungs-Messmodul gelten für den nachstehend beschriebenen erfindungsgemäßen Baugruppenträger entsprechend. Ebenso gelten die nachstehenden Ausführungen und Bevorzugungen im Hinblick auf den erfindungsgemäßen Baugruppenträger für das erfindungsgemäße HF-Leistungs-Messmodul entsprechend.

Die vorstehend genannte Aufgabe wird in einem zweiten Aspekt der vorliegenden Erfindung durch einen Baugruppenträger gelöst, umfassend
- ein Trägergehäuse (8),
- zumindest zwei in dem Trägergehäuse (8) vorgesehene Aufnahmeschächte (9), wobei diese Aufnahmeschächte (9) geometrisch dazu ausgelegt sind, jeweils ein erfindungsgemäßes HF-Leistungs-Messmodul, wie es vorstehend beschrieben wurde, aufzunehmen,
- in jedem der Aufnahmeschächte (9) eine zweite Steckvorrichtung mit Verriegelungseinrichtung und Betriebsspannungszuführung, in welche die erste Steckvorrichtung (5) mit Verriegelungseinrichtung und Betriebsspannungszuführung des erfindungsgemäßen HF-Leistungs-Messmoduls, wie es vorstehend beschrieben wurde, eingreift,
- eine interne Stromversorgung-Anschlusseinheit, welche auf der Rückseite der Aufnahmeschächte (9) angeordnet ist,
- eine austauschbare Stromversorgung (10).

Mit "Baugruppenträger" wird erfindungsgemäß eine Vorrichtung verstanden, in der mehrere Baugruppen, im vorliegenden Fall insbesondere ein oder mehrere erfindungsgemäße HF-Leistungs-Messmodule, aufgenommen werden können, wobei der erfindungsgemäße Baugruppenträger gleichzeitig die mechanische Halterung und Lagerung wie auch die elektrischen und signaltechnischen Verbindungen herstellt.

Unter "Aufnahmeschacht" wird erfindungsgemäß eine Öffnung in dem Baugruppenträger verstanden, in welche eine Baugruppe, hier ein erfindungsgemäßes HF-Leistungs-Messmodul, aufgenommen werden kann.

Die in dem erfindungsgemäßen Baugruppenträger für jeden der Aufnahmeschächte (9) vorgesehene zweite Steckvorrichtung, welche sich auf einer internen Verbindungsplatine befindet, bildet mechanisch und elektrisch einen Gegenpol zu der ersten Steckvorrichtung (5) an dem erfindungsgemäßen HF-Leistungs-Messmodul. Des Weiteren wird automatisch beim Einstecken eine Verbindung zum internen Netzwerkswitch intern hergestellt, um die Ethernet-Verbindung nach außen kabelgebunden oder über WLAN zu ermöglichen.

Mit "austauschbarer Stromversorgung" wird im Rahmen der vorliegenden Erfindung ein rückseitiger Schacht zur Aufnahme einer Stromversorgungseinheit bezeichnet.

Der erfindungsgemäße Baugruppenträger weist zunächst den Vorteil auf, dass er eine solide mechanische und funktionelle Basis für die erfindungsgemäßen flexiblen und gut handhabbaren HF-Leistungs-Messmodule bildet. Diese lassen sich in dem Baugruppenträger bei gleichzeitiger automatische Anbindung der Stromversorgung (6) und der zur Verfügung gestellten Kommunikationsverbindung (z.B. Ethernet) sicher aufnehmen.

Die Kombination aus erfindungsgemäßem Baugruppenträger und erfindungsgemäßen HF-Leistungs-Messmodulen ermöglicht eine variable Handhabung der HF-Leistungs-Messmodule für den mobilen Einsatz oder für die stationäre Verwendung. Darüber hinaus wird ein schneller und unkomplizierter Austausch defekter Geräte ermöglicht, quasi im Modus "plug and play", ohne dabei sich in Betrieb befindliche Module ausbauen, außer Betrieb zu nehmen oder Verkabelungen entfernen zu müssen.

Ein weiterer erfindungsgemäßer Vorteil besteht in der Implementierung diverser frei definierbarer Warnungs- und Alarmfunktionen, um abweichende, noch tolerierbare Pegel und nicht mehr tolerierbare Pegel zu signalisieren.

In einer Weiterbildung des erfindungsgemäßen Baugruppenträgers umfasst dieser ferner einen internen Ethernet Switch (11) für die Anbindung an ein Netzwerk. Somit muss nicht jedes eingebaute Modul extra verkabelt, sondern kann über einen gemeinsamen Ethernetport rückseitig betrieben werden.

Für die freie Verwendbarkeit in standardisierten Schaltanlagen hat es sich als vorteilhaft erweisen, wenn der Baugruppenträger die Maße 482 mm x 44 mm x 280 mm (d.h. B x H x T) aufweist. Das Baumaß dieser Breite entspricht den üblichen 19 Zoll (19").

Die Maße des erfindungsgemäßen HF-Leistungs-Messmoduls sind so gewählt, dass neben der flexiblen Handhabbarkeit im mobilen Einsatz erfindungsgemäß vier HF-Leistungs-Messmodule nebeneinander in den Baugruppenträger passen. Bereits eingebaute und sich in Betrieb befindliche HF-Leistungs-Messmodule werden durch den weiteren Einbau bzw. deren Ausbau nicht in ihrer Funktion bzw. ihrem Betrieb gestört oder unterbrochen.

Die vorstehend genannte Aufgabe wird in einem dritten Aspekt der vorliegenden Erfindung durch eine HF-Messeinheit gelöst, umfassend
- einen erfindungsgemäßen Baugruppenträger, wie er vorstehend beschrieben wurde,
- zumindest ein erfindungsgemäßes HF-Leistungs-Messmodul, wie es vorstehend beschrieben wurde, das in einem der Aufnahmeschächte (9) des Baugruppenträgers aufgenommen ist.

Die erfindungsgemäße HF-Messeinheit weist grundsätzlich die gleichen Vorteile auf, die vorstehend im Zusammenhang mit dem erfindungsgemäßen HF-Leistungs-Messmodul und dem erfindungsgemäßen Baugruppenträger schon erläutert wurden.

Weitere Ziele, Merkmale, Vorteile und Anwendungsmöglichkeiten ergeben sich aus der nachfolgenden Beschreibung. Die Erfindung wird durch die beigefügten Ansprüche definiert.

Es zeigt:
- Fig. 1:: eine schematische perspektivische Ansicht eines erfindungsgemäßen HF-Leistungs-Messmoduls nach einer Ausführungsform der Erfindung von vorne,
- Fig. 2:: eine schematische perspektivische Ansicht eines erfindungsgemäßen HF-Leistungs-Messmoduls nach einer Ausführungsform der Erfindung von hinten,
- Fig. 3:: eine schematische perspektivische Ansicht eines erfindungsgemäßen Baugruppenträgers nach einer Ausführungsform der Erfindung von vorne,
- Fig. 4:: eine schematische perspektivische Ansicht eines erfindungsgemäßen Baugruppenträgers nach einer Ausführungsform der Erfindung von hinten,
- Fig. 5:: eine schematische Darstellung eines erfindungsgemäßen HF-Leistungs-Messmoduls für erhöhten Dynamikbereich für diverse Frequenzbereiche und
- Fig. 6: eine schematische Darstellung des Aufbaus eines erfindungsgemäßen Baugruppenträgers zur Integration mehrerer erfindungsgemäßer HF-Leistungs-Messmodule.

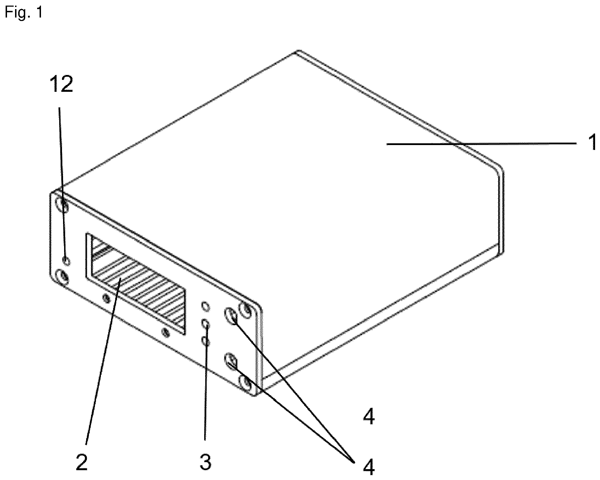

In Figur 1 wird das erfindungsgemäße HF-Leistungs-Messmodul in einer bevorzugten Ausführungsform schematisch in der Perspektive von vorne dargestellt. In der Front des Gehäuses 1 sind bedienungsfreundlich die Anzeigeeinrichtung 2, hier ein Display, die Bedieneinrichtung 3, hier in Form von Schaltern, und zwei HF-Eingänge dargestellt. Eine Status-Anzeige 12 zeigt visuell in Rot einen aufgetretenen Störungszustand am HF-Leistungs-Messmodul an, welcher entweder einen auftretenden Pegelverlust oder eine Pegelüberhöhung jeweils außerhalb der eingestellten Warnungs- oder Alarmschwelle bei der Messung desselben erreicht bzw. überschritten hat. Weitere Zustandsinformationen können direkt an dem Display (Anzeigeeinrichtung 2) abgelesen werden.

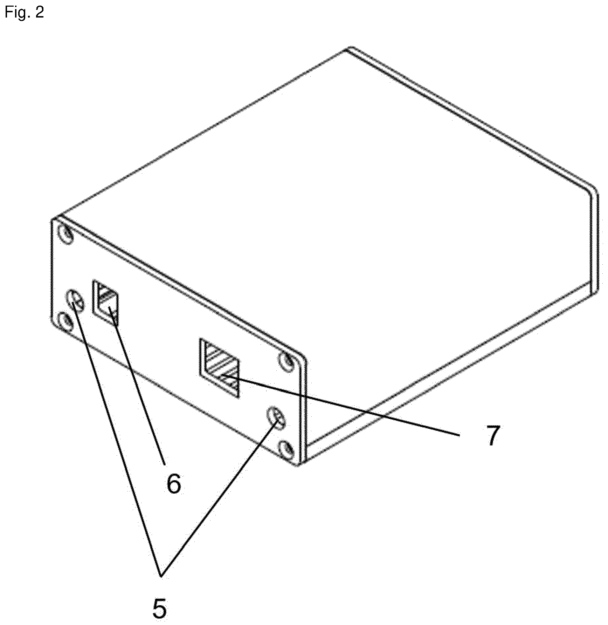

In Figur 2 wird das erfindungsgemäße HF-Leistungs-Messmodul in einer bevorzugten Ausführungsform schematisch in der Perspektive von hinten dargestellt. In der Rückseite des Gehäuses 1 sind völlig bedienungsfrei zwei erste Steckvorrichtungen 5, die externe Stromversorgung 6 und eine Kommunikationsschnittstelle 7 dargestellt.

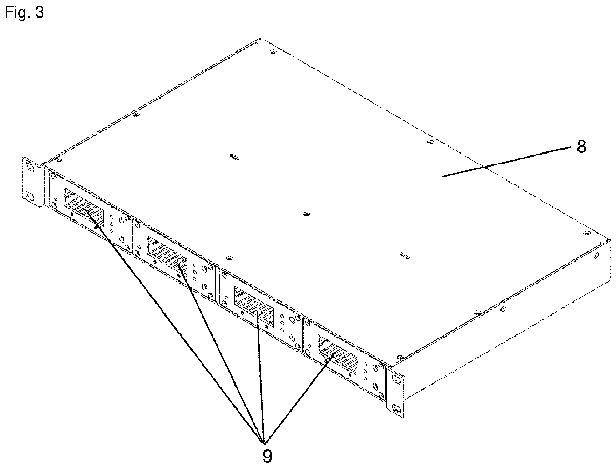

In Figur 3 wird der erfindungsgemäße Baugruppenträger in einer bevorzugten Ausführungsform schematisch in der Perspektive von vorne dargestellt. In der Front des Trägergehäuses 8 sind bedienungsfreundlich die Aufnahmeschächte 9 angeordnet, in denen in der Darstellung der Figur 3 jeweils ein erfindungsgemäßes HF-Leistungs-Messmodul aufgenommen ist.

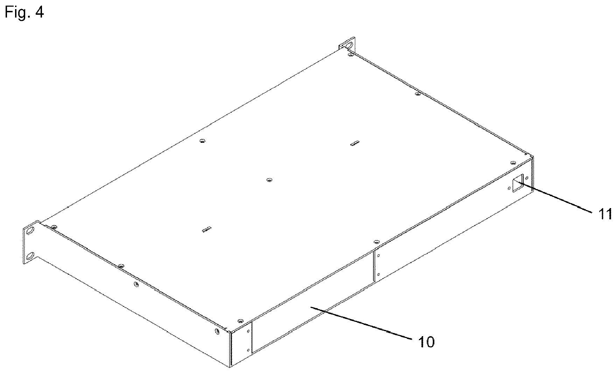

In Figur 4 wird der erfindungsgemäße Baugruppenträger in einer bevorzugten Ausführungsform schematisch in der Perspektive von hinten dargestellt. In der Rückseite des Trägergehäuses 8 sind bedienungsfreundlich die austauschbare Stromversorgung 10 und der Anschluss für den Ethernet Switch 11 angeordnet.

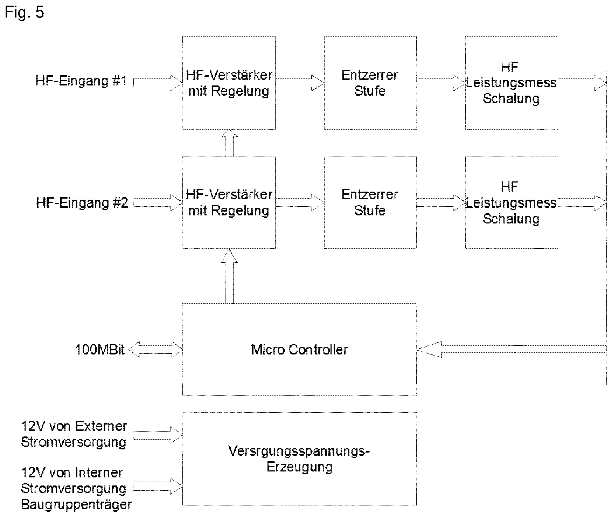

In Figur 5 wird die prinzipielle Funktionsweise des HF-Leistungs-Messmoduls dargestellt. Es handelt sich hier exemplarisch um einen HF-Leistungs-Messmodul mit zwei getrennten Eingängen. Jeder Eingang verfügt über einen regelbaren, mehrstufigen Verstärker mit Entzerrung und Kompensation der frequenzbedingten Verluste. Die anschließende Mess-Schaltung erzeugt eine in Abhängigkeit der HF Eingangsleistung störungsfreie Gleichspannung, welche von dem Mikro-Controller über einen Analog-Digital-Wandler aufgenommen und weiterverarbeitet wird. Die Stromversorgung des kompletten HF-Leistungs-Messmoduls kann entweder über ein externes Netzteil (Steckernetzteil) oder über das interne Netzteil des Baugruppenträgers nach Einbau in denselben versorgt werden.

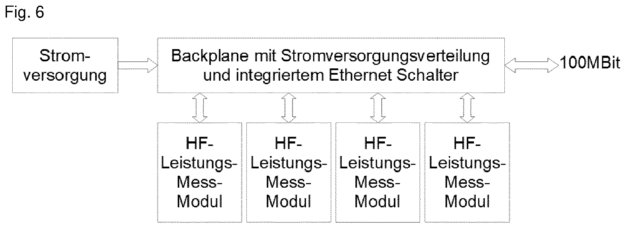

In Figur 6 wird der prinzipielle Aufbau des Baugruppenträgers dargestellt. Dieser enthält zur Aufnahme von zwei oder mehr HF-Leistungs-Messmodulen eine interne Leiterplatte mit Stromverteilung und Netzwerk-Verteilung. Die eingesteckten HF-Leistungs-Messmodule werden somit automatisch mit der nötigen Versorgungsspannung versorgt und die Netzwerkschnittstelle über den internen Ethernet Schalter rückseitig zur Verfügung gestellt.

Die vorliegende Erfindung definiert ein Gerätekonzept aus HF-Leistungs-Messmodul und Baugruppenträger zur Überwachung der hochfrequenten Leistung in einem Frequenzbereich zwischen ca. 1 MHz und mehreren GHz, je nach Anforderung wie z.B. das L-Band als Satelliten Zwischenfrequenzbereich.

Das erfindungsgemäße HF-Leistungs-Messmodul ist als Modul (Handheld-Gerät) ausgelegt mit externer Stromversorgung 6, einem Display 2 zur Anzeige, einer Status Anzeige 12 in Rot für Alarm-Anzeigen, Tasten 3 zur Bedienung, mindestens einem oder mehreren HF-Eingängen 4, einer Ethernet-Schnittstelle 7 für den Zugriff mittels Web-Browser und SNMP (Simple Network Management Protocol) und einer ersten Steckvorrichtung 5 (Buchse) für die automatische Adaptierung mit Verriegelung und gleichzeitiger Zuführung der Betriebsspannung beim Einbau in einen Baugruppenträger.

Der Einbau des erfindungsgemäßen HF-Leistungs-Messmodul in einen erfindungsgemäßen Baugruppenträger ermöglicht den kompakten Aufbau mehrerer Wattmeter auf kleinstem Raum, was eine Überwachung einer Übertragungsstrecke z.B. in einer Satelliten-Bodenstation oder einer ähnlichen Einrichtung sehr einfach und übersichtlich macht. Der Einbau der erfindungsgemäßen HF-Leistungs-Messmodule in den erfindungsgemäßen Baugruppenträger erfolgt durch einfaches Einstecken des HF-Leistungs-Messmoduls in einen freien Aufnahmeschacht 9, welcher das HF-Leistungs-Messmodul beim Einrasten automatisch mit Spannung aus dem internen Netzteil versorgt, sowie gleichzeitig eine Verbindung zu dem internen Ethernet Switch 11 herstellt, damit der Ethernet-Zugriff über die externe Ethernet Schnittstelle 7 gewährleistet ist. Es gibt keine nötigen Verschraubungen oder Verriegelungen beim Ein- bzw. Ausbau der HF-Leistungs-Messmodule in den Baugruppenträger, somit müssen auch keine existierenden Verkabelungen gelöst werden.

Das erfindungsgemäße HF-Leistungs-Messmodul ist, je nach Bedarf des Frequenzbereiches, in unterschiedlichen Konfigurationen bzgl. des zu messenden Frequenzbereiches erhältlich.

Das erfindungsgemäße HF-Leistungs-Messmodul (Modul PwrM3G) ist für einen Frequenzbereich bis 3 GHz ausgelegt. Die Messdynamik liegt hier bei 95 dB, der Messbereich erfolgt von + 20 dBm bis - 75 dBm, bei einer durchgängigen Genauigkeit von +/- 1 dB.

Das erfindungsgemäße HF-Leistungs-Messmodul (Modul PwrM8G) ist für einen Frequenzbereich bis 8 GHz ausgelegt. Die Messdynamik liegt hier bei ca. 60 dB, der Messbereich erfolgt von + 10 dBm bis - 60 dBm, bei einer durchgängigen Genauigkeit von +/- 2 dB.

Ein erfindungsgemäßes HF-Leistungs-Messmodul (Modul PwrM14G) würde das hier entsprechende Pendant für Frequenzen bis KU-Band (Mikrowellenfrequenzband im Bereich 10,7 GHz bis 17,5 GHz) und höher bezeichnen.

Alle hier beschriebenen erfindungsgemäßen HF-Leistungs-Messmodule haben grundsätzlich für den datenverarbeitenden und steuernden Teil den gleichen Aufbau bestehend aus einem Ethernet-Controller, einem internen Mikroprozessor, einer rauscharmen Stromversorgung 6 und den internen Schnittstellen zu den HF-Eingangsstufen.

Die HF-Eingangsstufen bestehen aus mehreren regelbaren Verstärkern mit Frequenzgang, Optimierung und Temperaturkompensation mit anschließender Pegelmesseinrichtung zur Erfassung der HF-Leistung.

Der Aufbau erfolgt mit handelsüblichen Bauteilen diverser Halbleiterhersteller, um das Kostenniveau niedrig zu halten. Um einen hohen Dynamikbereich zu erreichen, werden die jeweiligen Vorstufen mittels Verstärkern und Dämpfungseinrichtungen aufgebaut.

### Bezugszeichenliste

- 1: Gehäuse
- 2: Anzeigeeinrichtung
- 3: Bedieneinrichtung
- 4: HF-Eingang
- 5: erste Steckvorrichtung
- 6: externe Stromversorgung
- 7: Kommunikationsschnittstelle
- 8: Trägergehäuse
- 9: Aufnahmeschacht
- 10: austauschbare Stromversorgung
- 11: Ethernet Schnittstelle
- 12: Status-Anzeige
- HF: Hochfrequenz

## Patentansprüche

1. HF-Leistungs-Messmodul umfassend
- eine Messeinrichtung für Hochfrequenzleistung mit Mikroprozessor und zumindest einer HF-Schnittstelle zu einer HF-Eingangsstufe,
- eine externe Stromversorgung (6) für die Messeinrichtung,
- ein Gehäuse (1), aufweisend
- eine Anzeigeeinrichtung (2),
- eine Status-Anzeige (12),
- eine Bedieneinrichtung (3),
- zumindest zwei HF-Eingänge (4),
- zumindest eine Kommunikationsschnittstelle (7),
wobei das Gehäuse (1) eine erste Steckvorrichtung (5) mit Verriegelungseinrichtung und Betriebsspannungszuführung aufweist,
ferner umfassend eine Schaltung zur Erweiterung des Dynamikbereichs der HF-Messung mit und für integrierte Schaltungen.

2. HF-Leistungs-Messmodul nach Anspruch 1, wobei die Messeinrichtung ferner einen Ethernet-Controller aufweist.

3. HF-Leistungs-Messmodul nach Anspruch 1 oder 2, wobei die Stromversorgung (6) für die Messeinrichtung rauscharm ausgeführt ist.

4. HF-Leistungs-Messmodul nach einem der Ansprüche 1 bis 3, wobei die zumindest eine Kommunikationsschnittstelle (7) eine Ethernet-Schnittstelle ist.

5. HF-Leistungs-Messmodul nach einem der Ansprüche 1 bis 4, wobei das HF-Leistungs-Messmodul die Maße 105 mm x 40 mm x 125 mm aufweist.

6. Baugruppenträger umfassend
- ein Trägergehäuse (8),
- zumindest zwei in dem Trägergehäuse (8) vorgesehene Aufnahmeschächte (9), wobei diese Aufnahmeschächte (9) geometrisch dazu ausgelegt sind, jeweils ein HF-Leistungs-Messmodul nach einem der Ansprüche 1 bis 5 aufzunehmen,
- in jedem der Aufnahmeschächte (9) eine zweite Steckvorrichtung mit Verriegelungseinrichtung und Betriebsspannungszuführung vorgesehen ist, in welche die erste Steckvorrichtung (5) mit Verriegelungseinrichtung und Betriebsspannungszuführung des HF-Leistungs-Messmoduls nach einem der Ansprüche 1 bis 5 eingreift,
- eine interne Stromversorgung-Anschlusseinheit, welche auf der Rückseite der Aufnahmeschächte (9) angeordnet ist,
- eine austauschbare Stromversorgung (10).

7. Baugruppenträger nach Anspruch 6, ferner umfassend einen internen Ethernet Switch (11) für die Anbindung an ein Netzwerk.

8. Baugruppenträger nach Anspruch 6 oder 7, wobei der das Baugruppenträger die Maße 482 mm x 44 mm x 280 mm aufweist.

9. HF-Messeinheit, umfassend
- einen Baugruppenträger nach einem der Ansprüche 6 bis 8,
- zumindest ein HF-Leistungs-Messmodul nach einem der Ansprüche 1 bis 5, das in einem der Aufnahmeschächte (9) des Baugruppenträger aufgenommen ist.

## Claims

1. RF power measurement module comprising
- a measuring device for high-frequency power with a microprocessor and at least one RF interface to an RF input stage,
- an external power supply (6) for the measuring device,
- a housing (1), comprising
- a display device (2),
- a status display (12),
- an operating device (3),
- at least two RF inputs (4),
- at least one communication interface (7),
wherein the housing (1) has a first plug-in device (5) with locking device and operating voltage supply,
further comprising a circuit for extending the dynamic range of the RF measurement with and for integrated circuits.

2. RF power measurement module according to claim 1, wherein the measurement device further comprises an Ethernet controller.

3. RF power measurement module according to claim 1 or 2, wherein the power supply (6) for the measuring device is designed with low noise.

4. RF power measurement module according to one of claims 1 to 3, wherein the at least one communication interface (7) is an Ethernet interface.

5. RF power measurement module according to one of claims 1 to 4, wherein the RF power measurement module has the dimensions 105 mm x 40 mm x 125 mm.

6. Subrack comprising
- a carrier housing (8),
- at least two receiving shafts (9) provided in the carrier housing (8), wherein these receiving shafts (9) are geometrically designed to each receive an RF power measurement module according to one of claims 1 to 5,
- a second plug-in device with locking device and operating voltage supply is provided in each of the receiving shafts (9), into which the first plug-in device (5) with locking device and operating voltage supply of the RF power measurement module according to one of claims 1 to 5 engages,
- an internal power supply connection unit, which is arranged on the rear side of the receiving shafts (9),
- a replaceable power supply (10).

7. Subrack according to claim 6, further comprising an internal Ethernet switch (11) for connection to a network.

8. Subrack according to claim 6 or 7, wherein the subrack has the dimensions 482 mm x 44 mm x 280 mm.

9. RF measuring unit, comprising
- a subrack according to any one of claims 6 to 8,
- at least one RF power measurement module according to one of claims 1 to 5, which is accommodated in one of the receiving shafts (9) of the subrack.

## Revendications

1. RF power measurement module comprising
- un système de mesure de puissance haute fréquence avec un microprocesseur et au moins une interface HF avec un étage d'entrée HF,
- une alimentation électrique externe (6) pour le système de mesure,
- un boîtier (1) présentant
- un système d'affichage (2),
- un affichage de statut (12),
- un système de commande (3),
- au moins deux entrées HF (4),
- au moins une interface de communication (7),
dans lequel le boîtier (1) présente un premier dispositif d'enfichage (5) avec un système de verrouillage et une amenée de tension de service,
comprenant en outre un circuit destiné à étendre la plage dynamique de la mesure HF avec et pour des circuits intégrés.

2. Module de mesure de puissance HF selon la revendication 1, dans lequel le système de mesure présente en outre un dispositif de commande Ethernet.

3. Module de mesure de puissance HF selon la revendication 1 ou 2, dans lequel l'alimentation électrique (6) pour le système de mesure est réalisée de manière silencieuse.

4. Module de mesure de puissance HF selon l'une quelconque des revendications 1 à 3, dans lequel l'au moins une interface de communication (7) est une interface Ethernet.

5. Module de mesure de puissance HF selon l'une quelconque des revendications 1 à 4, dans lequel le module de mesure de puissance HF présente les dimensions 105 mm x 40 mm x 125 mm.

6. Support de module comprenant
- un boîtier de support (8),
- au moins deux compartiments de réception (9) prévus dans le boîtier de support (8), dans lequel lesdits compartiments de réception (9) sont conçus sur le plan géométrique pour recevoir respectivement un module de mesure de puissance HF selon l'une quelconque des revendications 1 à 5,
- dans chacun des compartiments de réception (9), un deuxième dispositif d'enfichage avec un système de verrouillage et une amenée de tension de service est prévu, avec lequel le premier dispositif d'enfichage (5) vient en prise avec le système de verrouillage et l'amenée de tension de service du module de mesure de puissance HF selon l'une quelconque des revendications 1 à 5,
- une unité de raccordement d'alimentation électrique interne, laquelle est disposée sur le côté arrière des compartiments de réception (9),
- une alimentation électrique (10) interchangeable.

7. Support de module selon la revendication 6, comprenant en outre un commutateur Ethernet interne (11) pour le rattachement à un réseau.

8. Support de module selon la revendication 6 ou 7, dans lequel le support de module présente les dimensions 482 mm x 44 mm x 280 mm.

9. Unité de mesure HF, comprenant
- un support de module selon l'une quelconque des revendications 6 à 8,
- au moins un module de mesure de puissance HF selon l'une quelconque des revendications 1 à 5, qui est reçu dans un des compartiments de réception (9) du support de module.
